# EUROPEAN PATENT SPECIFICATION

(11) **EP 1 085 971 B1**
(45) Date of publication and mention of the grant of the patent: **02.06.2004**
(21) Application number: 00913846.2
(22) Date of filing: 09.03.2000
(51) Int. Cl.: B29C 67/00, B29C 37/00, G03F 7/00

(54) **APPLICATION OF TEXTURED OR PATTERNED SURFACES TO A PROTOTYPE**
AUFTRAGEN VON TEXTURIERTEN ODER GEMUSTERTEN OBERFLÄCHEN AUF EINEN PROTOTYP
APPLICATION DE SURFACES STRUCTUREES OU A MOTIF SUR UN PROTOTYPE

(30) Priority: 09.03.1999 US 123464 P
(43) Date of publication of application: 28.03.2001
(73) Proprietor: Eisinger, Lee, Akron, OH 44307 (US)
(72) Inventor: Eisinger, Lee, Akron, OH 44307 (US)
(74) Representative: Freischem, Stephan, Dipl.-Ing.
(86) International application number: PCT/US2000/006205
(87) International publication number: WO 2000/053398

(56) References cited:
- EP-A- 0 442 071
- WO-A-98/33761
- GB-A- 1 421 779
- GB-A- 2 035 602
- US-A- 4 444 607
- US-A- 4 696 890
- US-A- 4 914 004
- PATENT ABSTRACTS OF JAPAN vol. 009, no. 331 (C-321), 25 December 1985 (1985-12-25) -& JP 60 161772 A (TOYOTA JIDOSHA KK), 23 August 1985 (1985-08-23)

## Description

### Background of the Invention

### 1. Field of Invention

This invention pertains to the art of rapid prototyping technological methods and apparatuses for producing an end product that is an exact model of a 3-dimensional drawing, and more specifically, to a method for applying a texture or pattern to the surface of a prototype part.

### 2. Description of the Related Art

The need for rapid prototyping is known in the art in order to reduce design iterations, production, and tooling costs. One process used to quickly produce prototype parts is called stereolithography, or SLA. While there are various manufacturers of the equipment used to produce the same type of product, the resulting item is generally referred to as a SLA part or model. The term prototype parts refers to a part to be used for display or sample purposes. The process used to manufacture this prototype part is not germane to this application.

Stereolithography is a 3-dimensional printing process that produces a solid plastic model. The process involves automating a laser to draw or print cross sections of the model onto the surface of photo-curable liquid plastic.

Stereolithography creates a tangible 3-dimensional object from a computer aided drawing (CAD) by directing ultraviolet laser radiation onto a vat of polymer resin, liquid plastic. Using a stereolithography apparatus (SLA), the CAD model data is sliced by proprietary software into to very thin cross sections. The laser generates a small intense spot of ultraviolet (UV) light, which is moved across the top of a vat of liquid photopolymer into a solid where it touches, precisely printing each cross-section. A vertical elevator system lowers the newly formed layer while a leveling system establishes the thickness of the next layer.

Successive cross-sections, each of which adheres to the one below it, are built one layer on top of another to form the part from the bottom up. After the last layer is made, the part is removed from the SLA and flooded with high intensity UV light to complete the polymerization process. In the art, the surface of the part is then finished by various methods including sanding, sandblasting, painting, or dyeing. Also, each piece can be hand polished and finished to specifications.

Rapid prototyping is useful in order to turn an idea into a prototype within a matter of hours thereby allowing one to find errors, make design improvements, and analyze an end product without impacting the time-to-market. However, prototypes made by these known processes do not include the fine detailed surface finishing of an actual product.

In the field of microlithography, photo resist compositions are used in processes for making miniaturized electronic components such as computer chips and integrated circuits. In these types of processes, a thin coating of a photo resist is applied to a silicon substrate. Portions of the substrate are masked or otherwise prevented from exposure to a radiation source, such as visible light, ultraviolet light, electron beams, or X-rays. The photo resist on the exposed portions are chemically altered to become either more (positive-working) or less (negative-working) soluble in a developing solution. In either case, portions of the photo resist coating are removed after exposure to provide an altered substrate surface.

GB-A-2 035 602 discloses a method for providing a raised feature on a surface of a prototype model by the steps of:
- providing the prototype model having at least one surface on which to provide the raised feature;
- coating the surface with a photo-resist;
- providing means in the form of a film image for preventing exposure of a first portion of the photo-resist to a radiation source while allowing exposure of a second portion of the photo-resist when the second portion of the photo-resist provides the raised feature;
- exposing the surface to the radiation source to chemically alter the second portions of the photo-resist;
- removing the first portion of the photo-resist from the surface while leaving the raised feature in the form of a pattern formed by the exposed photo-resist on the surface.

Another method is known from US-A-4 914 004. This reference refers to a process for the production of polymeric coatings from a two-layer system. This is effected by irradiating the monomers or oligomers present on an initiator layer with a light source. After irradiation, non-cured constituents present above the polymer layer are removed by washing with a suitable solvent. US-A-914 004 also refers to a process for the production of relief structures by irradiating a two-layer systems through a copying layer or mask. The relief structures are obtained after removing the areas not exposed to irradiation by washing.

EP-A-0 442 071 refers to a method for producing layers. It discloses that a three dimensional object might be produced by putting a plate into a container and covering it with a layer of dispersion. This layer is exposed to a light source in the form of a laser. After exposure, the plate is lowered in the container so that a new layer of dispersion covers the plate. This layer is again exposed to the light source. These steps are repeated several times. After finishing building up the object, the object is pulled out of the container and the dispersion which has not been polymerised by the action of light is removed by an air stream.

The present invention contemplates a new method for applying a texture or pattern to the surface of a prototype part using a photo resist composition. The improved method is simple in design, effective in use, and overcomes the difficulties in the related art while providing better and more advantageous overall results.

### Summary of the Invention

In accordance with the present invention, a new and improved method of applying a texture or pattern to the surface of a prototype part is provided which allows the prototype part to be finished to specifications and providing an exact replica of an actual product.

The present invention discloses a method to apply texture or pattern to a surface of a prototype part and will be discussed herein with respect to a prototype part formed by stereolithography as discussed above. However, the method of the present invention can be used for any prototype part including, but not limited to, plastic resins, wood, cardboard, metal, etc.

In accordance with one aspect of the invention, a method for providing a raised feature on a surface of a prototype model is provided. The method is defined in claim 1.

According to an embodiment of the invention, the surface of the prototype model is cleaned before the step of coating said surface with said photo resist.

According to another embodiment of the invention, the method further includes the steps of inspecting said raised feature after said step of removing said first portion of said photo resist, and repeating steps (b)- (e) to enhance said raised feature.

According to another embodiment of the invention, said step of providing a model is characterized by providing a model formed by a stereolithography process.

According to another embodiment of the invention, said step of providing a model is characterized by providing a drawing of a three-dimensional object and creating a model of said three-dimensional object by stereolithiography process.

One advantage of the present invention is that the end product is an exact model of the 3-D drawing giving designers, engineers, manufacturers, sales managers, marketing directors, and prospective customers the opportunity to handle the new part or product.

Another advantage of the invention is that design iterations can be made quickly and inexpensively, guaranteeing companies the best product possible, in the shortest time possible.

Another advantage of the invention is that the method for rapid prototyping allows one to have a tangible model at the time of quotes which greatly improves the accuracy of the quote.

Still other benefits and advantages of the invention will become apparent to those skilled in the art to which it pertains upon a reading and understanding of the following detailed specification.

### Brief Description of the Drawings

The invention may take physical form in certain parts and arrangement of parts, a preferred embodiment of which will be described in detail in this specification and illustrated in the accompanying drawings which form a part hereof and wherein:
Figure 1 is a representation of a book bag;
Figure 2 is a representation of the sole of an athletic shoe;
Figure 3 is a representation of a golf ball;
Figure 4 is a representation of a softball;
Figure 5 is a representation of a planter basket;
Figure 6 is a representation of a tire tread;
Figure 7 is a representation of a pot;
Figure 8 is a representation of an alternative pot;
Figure 9 is a representation of a piece of glassware;
Figure 10 is a representation of a handbag;
Figure 11 is a representation of a paperweight; and,
Figure 12 is a flow chart depicting the steps used in the inventive process.

### Description of the Preferred Embodiment

The drawings referred to herein are for purposes of illustrating a preferred embodiment of the invention only and not for purposes of limiting the same.

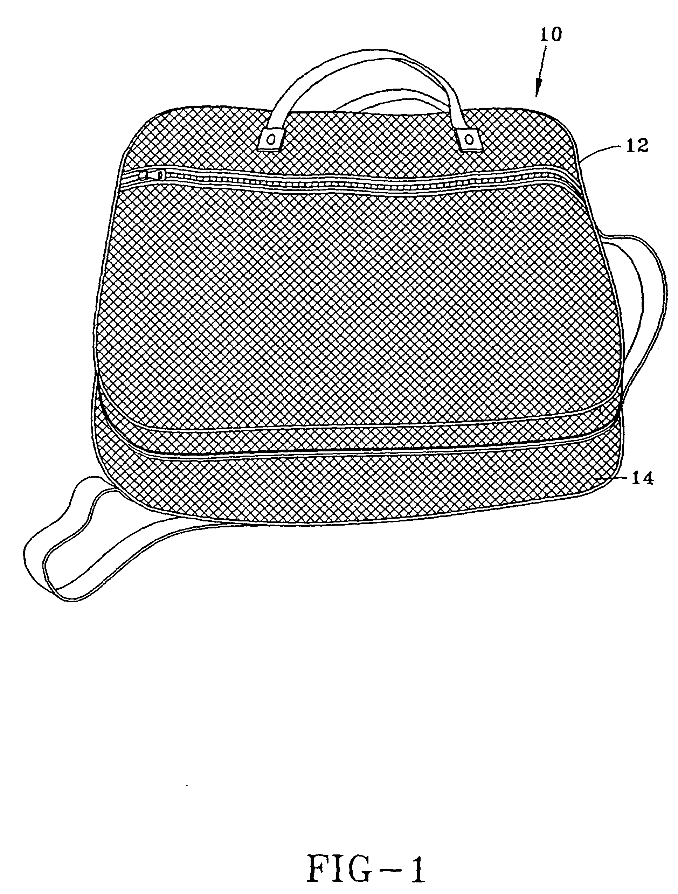

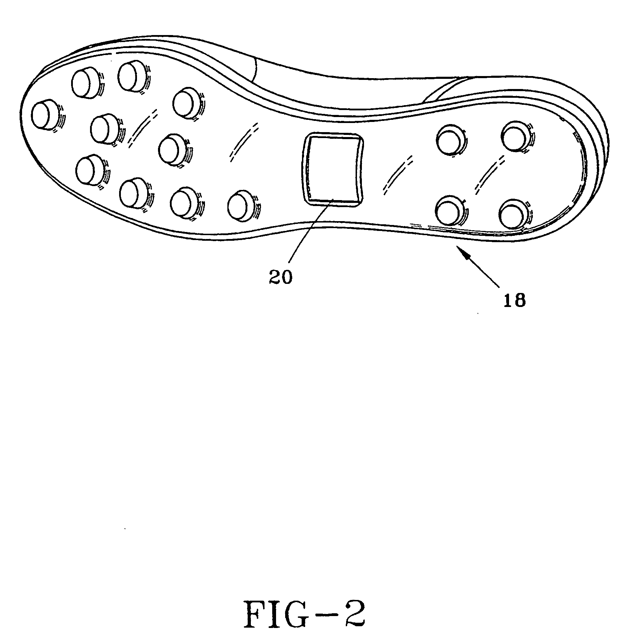

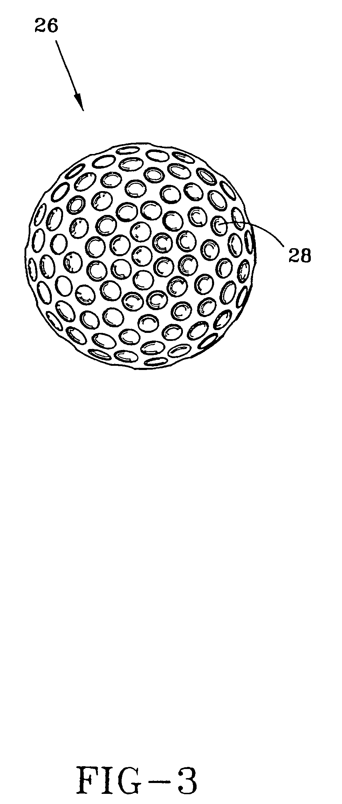

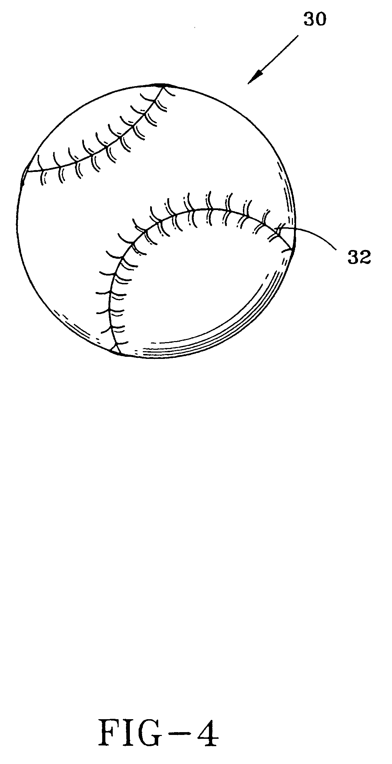

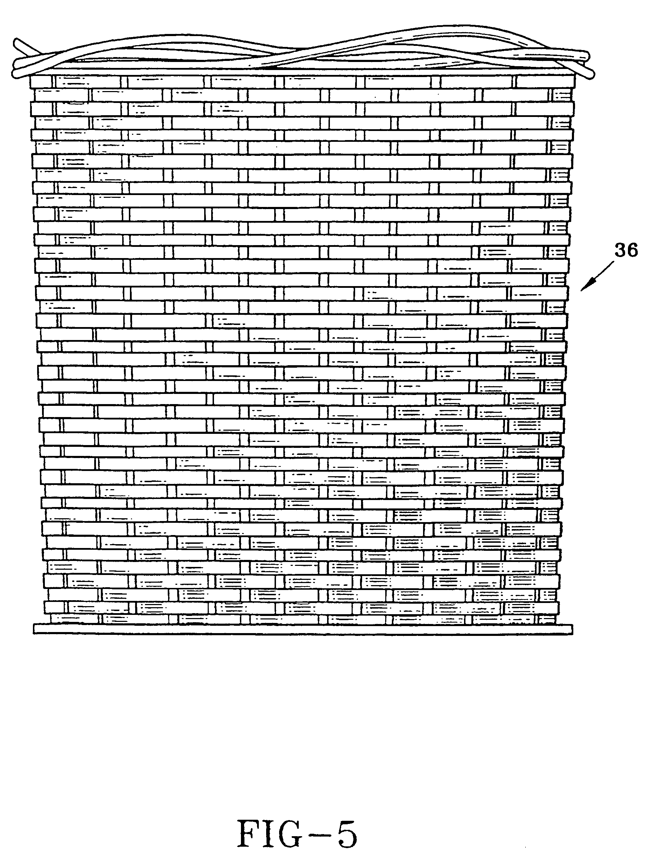

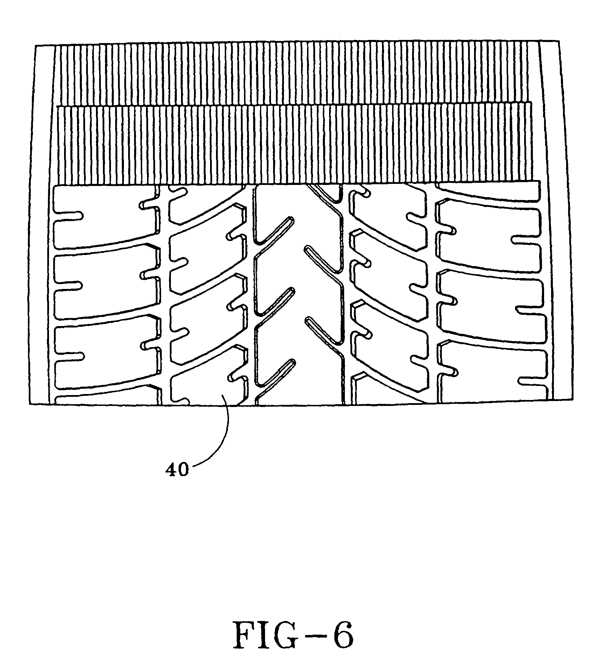

Figure 1 shows a book bag 10 having a textured surface 12. The cloth pattern 14 on this textured surface 12 can be made on a prototype part by use of the present invention. Figure 2 shows the sole of an athletic shoe 18. The logo 20 on the sole of this athletic shoe 18 may be produced by the current invention. Figure 3 shows a golf ball 26 showing the multitude of dimples 28 within the surface of the golf ball 26. These dimples 28 may be shown on a prototype model by using the method of the present invention. Figure 4 shows a softball 30 showing a thread pattern 32. Again, a pattern such as this may be shown on a prototype model. Figure 5 shows a planter basket 36 made from woven material. A replicate surface could be shown on a prototype model. Figure 6 shows a tread pattern 40. The texture and pattern of this surface is likewise able to be produced by the current invention.

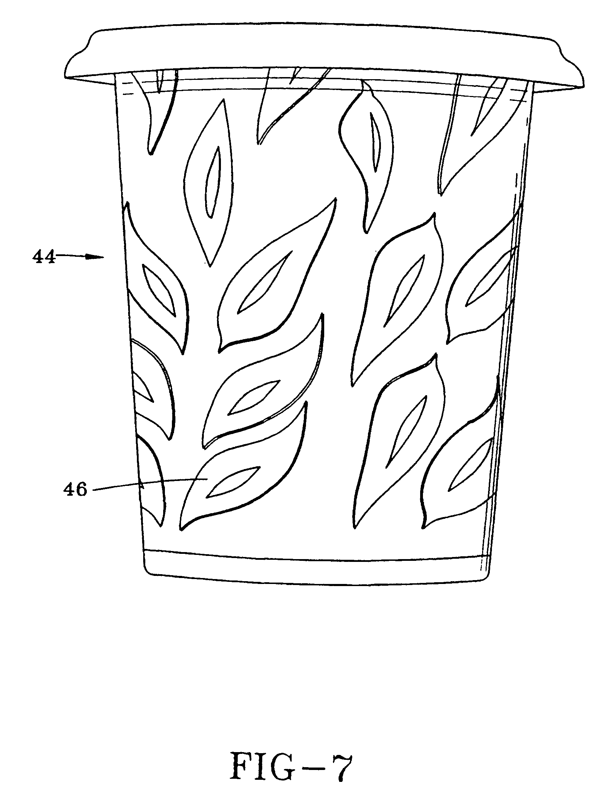

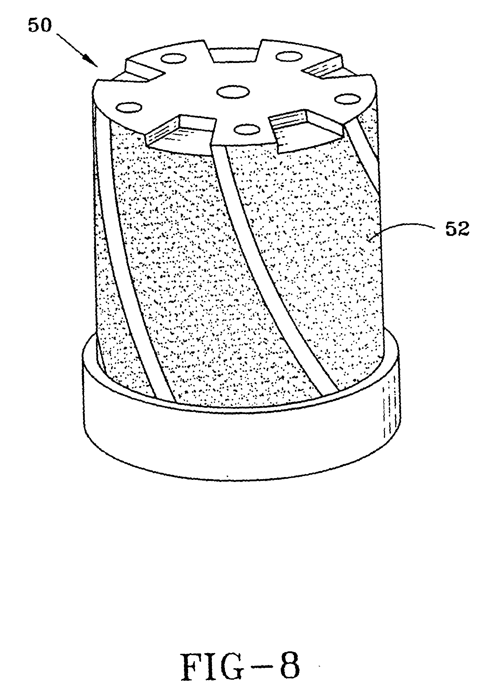

Figure 7 shows a ceramic pot 44 having an ornamental design 46 on its exterior. The ornamental design 46 could be produced on the surface of a prototype model by the current invention. Figure 8 shows an alternative plastic pot 50. The exterior surface 52 of this pot 50 has a rough surface design on it. The current invention may also be used to produce this surface design.

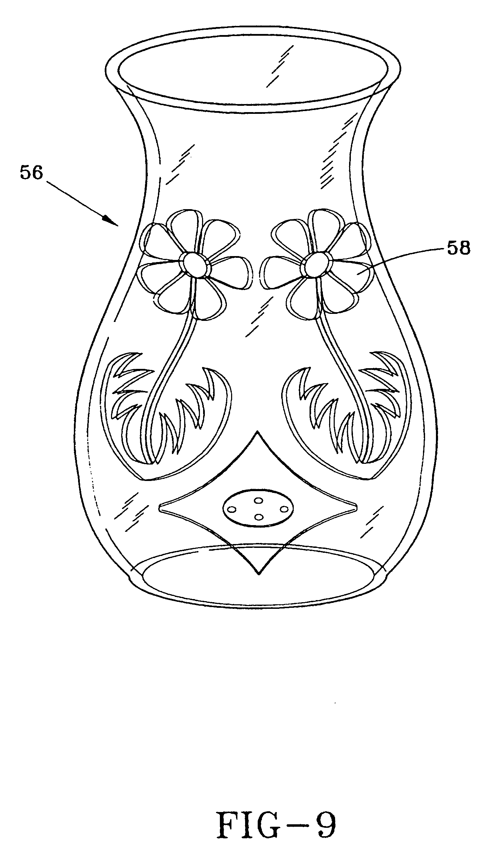

Figure 9 shows a piece of glassware 56 having various designs 58. In making an actual product, the designs 58 would be typically cut or pressed into the glassware 56. By using the present invention, designs could be considered and altered very quickly.

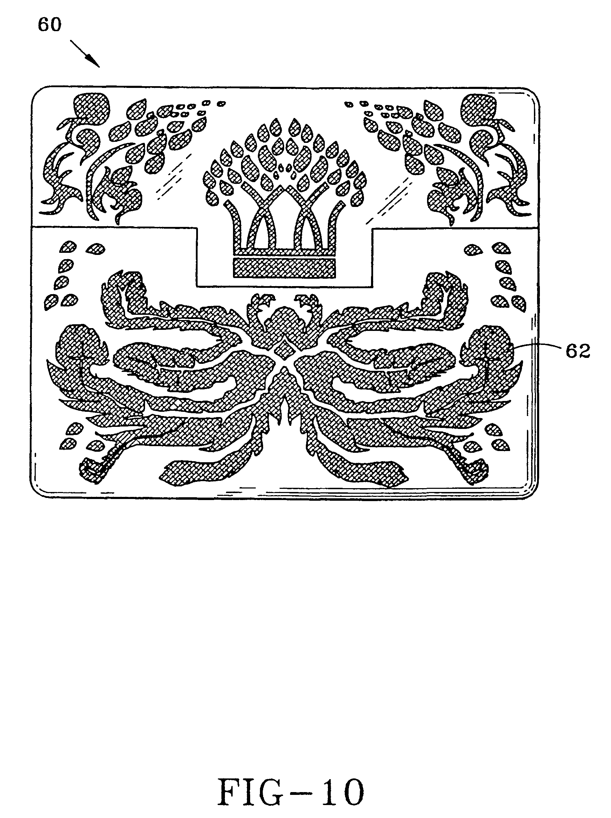

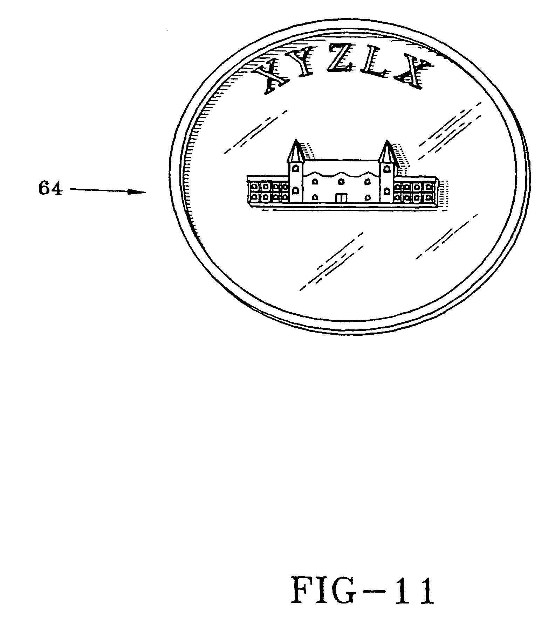

Figure 10 shows a cloth handbag 60 having a fanciful textured design 62 on it which may be produced on a prototype model by the current invention. Finally, Figure 11 shows a paperweight 64. Again, the design for the paperweight may be first produced on a prototype and modified if necessary by using the present invention before incurring the expense and time of actually producing the product.

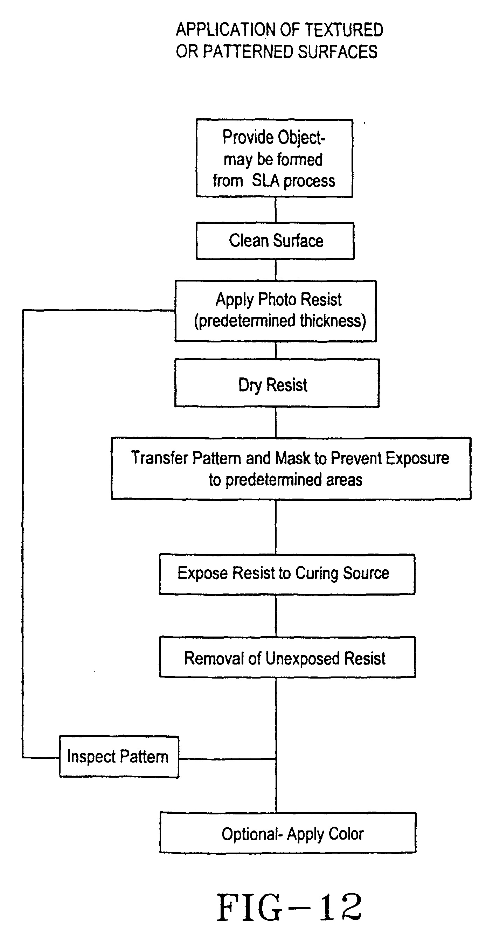

Figure 12 is directed to a flow chart showing the steps in the inventive process. The method generally includes the following steps. Firstly, a model is provided which has at least one surface on which a textured surface is desired. In the preferred embodiment, the model is formed by the known processes referred to herein as SLA. The desired surface is then coated with a photo resist to a predetermined thickness. The thickness will correspond to the desired height of any raised features formed on the surface. A pre-selected pattern is transferred to the surface and some portions are masked by coating with wax or film, or other means are provided for preventing exposure of pre-selected portions of the photo resist, while allowing exposure of other portions of the photo resist, to a radiation source. The portions which are allowed to be exposed are those portions which correspond to raised features of the pre-selected pattern. The surface is then exposed to a radiation source in order to chemically alter the exposed portions of the photo resist. The masking material is removed, if necessary, and the surface is treated with a developing medium in order to remove the unexposed photo resist from the surface, leaving behind the raised features formed by the hardened photo resist. At this point, the surface may be inspected for imperfections in the pattern. Application of additional photo resist and repetition of previous steps can enhance the raised features. Also, any softening or rounding of the edges can be accomplished by over coating the entire surface with additional photo resist.

The photo resist is applied in a series of layers, allowing sufficient drying time between successive applications in order to provide better adherence of the photo resist to the surface. The layers are preferably thin. Also in the preferred embodiment, the surface of the prototype model is cleaned before application of the photo resist, again to promote proper adhesion..

One key element of this disclosure is the concept of applying a raised pattern to an SLA model or any other item by using a photo-resist. The preferred prototype model of the present invention is formed by the above-described stereolithography process. However, the method described herein of applying a texture or pattern to the surface is not limited to a stereolithographic part and can also be used on other parts.

Finally, the present invention is not limited by the color of the object being produced. A component of the current invention can also be the application of different colors to the objects produced.

Figures 1-11 as detailed above are given as exemplary only and not by way of limiting the invention. Those skilled in the art will no doubt find may other applications for the methods of the present invention. The stereolithography processes known in the art are not able to produce the surface texturing given as examples above. It will be apparent to those skilled in the art that the above methods may incorporate changes and modifications without departing from the general scope of this invention. It is intended to include all such modifications and alterations in so far as they come within the scope of the appended claims.

## Claims

1. . A method for providing a raised feature (14, 20, 28, 32, 46, 52, 58, 62) on a surface (12) of a prototype model (10, 18, 26, 30, 36, 44, 50, 56, 60, 64) with the steps of:
(a) providing a model (10, 18, 26, 30, 36, 44, 50, 56, 60, 64) having at least one surface (12) on which to provide said raised feature (14, 20, 28, 32, 46, 52, 58, 62);
(b) coating said surface (12) with a photo resist to a predetermined thickness;
(c) providing means for preventing exposure of a first portion of said photo resist to a radiation source while allowing exposure of a second portion of said photo resist wherein said second portion of said photo resist provides said raised feature (14, 20, 28, 32, 46, 52, 58, 62);
(d) exposing said surface (12) to said radiation source to chemically alter said second portions of said photo resist;
(e) removing said first portion of said photo resist from said surface (12) while leaving said raised feature (14, 20, 28, 32, 46, 52, 58, 62) formed by said exposed photo resist on said surface (12);
**characterized by**
said step of coating said surface (12) with said photo resist to a predetermined thickness including the steps of applying said photo resist in more than one layer and allowing sufficient drying time between successive layers of said photo resist.

2. The method of claim 1, **further characterized by** the step of: cleaning said surface (12) of said prototype model (10, 18, 26, 30, 36, 44, 50, 56, 60, 64) before said step of coating said surface (12) with said photo resist.

3. The method of claim 1, **further characterized by** the steps of: inspecting said raised feature (14, 20, 28, 32, 46, 52, 58, 62) after said step of removing said first portion of said photo resist, and repeating steps (b)- (e) to enhance said raised feature (14, 20, 28, 32, 46, 52, 58, 62).

4. . The method of claim 1, wherein said step of providing a model (10, 18, 26, 30, 36, 44, 50, 56, 60, 64) is **characterized by** providing a model (10, 18, 26, 30, 36, 44, 50, 56, 60, 64) formed by a stereolithography process.

5. The method of claim 1, wherein said step of providing a model (10, 18, 26, 30, 36, 44, 50, 56, 60, 64) is **characterized by** providing a drawing of a three-dimensional object and creating a model (10, 18, 26, 30, 36, 44, 50, 56, 60, 64) of said three-dimensional object by stereolithiography process.

## Patentansprüche

1. Verfahren zum Bereitstellen eines erhöhten Elements (14, 20, 28, 32, 46, 52, 58, 62) auf einer Oberfläche (12) eines Modells eines Prototyps (10, 18, 26, 30, 36, 44, 50, 56, 60, 64) mit den Schritten:
(a)Bereitstellen eines Modells (10, 18, 26, 30, 36, 44, 50, 56, 60, 64) mit mindestens einer Oberfläche (12), auf der das erhöhte Element (14, 20, 28, 32, 46, 52, 58, 62) bereitzustellen ist;
(b)Beschichten der Oberfläche (12) mit einer lichtunempfindlichen Deckmasse auf eine vorbestimmte Dicke;
(c)Bereitstellen von Mitteln zum Verhindern der Belichtung eines ersten Teils der lichtunempfindlichen Deckmasse durch eine Strahlungsquelle, während die Belichtung eines zweiten Teils der lichtunempfindlichen Deckmasse ermöglicht wird, wobei der zweite Teil der lichtunempfindlichen Deckmasse das erhöhte Element (14, 20, 28, 32, 46, 52, 58, 62) bereitstellt;
(d)Belichten der Oberfläche (12) mit der Strahlungsquelle, um die zweiten Teile der lichtunempfindlichen Deckmasse chemisch zu verändern;
(e)Entfernen des ersten Teils der lichtunempfindlichen Deckmasse von der Oberfläche (12), während das erhöhte Element (14, 20, 28, 32, 46, 52, 58, 62), das durch die belichtete lichtunempfindliche Deckmasse gebildet wird, auf der Oberfläche (12) verbleibt;
**gekennzeichnet dadurch, daß**
der Schritt des Beschichtens der Oberfläche (12) mit der lichtunempfindlichen Deckmasse zu einer vorbestimmten Dicke die Schritte des Aufbringens der lichtunempfindlichen Deckmasse in mehr als einer Schicht und des Zulassens einer ausreichenden Trocknungszeit zwischen aufeinanderfolgenden Schichten der lichtunempfindlichen Deckmasse beinhaltet.

2. Verfahren nach Anspruch 1, **des weiteren gekennzeichnet durch** den Schritt des Reinigens der Oberfläche (12) des Modells des Prototyps (10, 18, 26, 30, 36, 44, 50, 56, 60, 64) vor dem Schritt des Beschichtens der Oberfläche (12) mit der lichtunempfindlichen Deckmasse.

3. Verfahren nach Anspruch 1, des weiteren **gekennzeichnet durch** die Schritte des Untersuchens des erhöhten Elements (14, 20, 28, 32, 46, 52, 58, 62) nach dem Schritt des Entfernens des ersten Teils der lichtunempfindlichen Deckmasse und des Wiederholens der Schritte (b) bis (e), um das erhöhte Element (14, 20, 28, 32, 46, 52, 58, 62) zu erweitern.

4. Verfahren nach Anspruch 1, wobei der Schritt des Bereitstellens eines Modells (10, 18, 26, 30, 36, 44, 50, 56, 60, 64) **gekennzeichnet ist durch** Bereitstellen eines Modells (10, 18, 26, 30, 36, 44, 50, 56, 60, 64), das **durch** ein Stereolithographie-Verfahren gebildet ist.

5. Verfahren nach Anspruch 1, wobei der Schritt des Bereitstellens eines Modells (10, 18, 26, 30, 36, 44, 50, 56, 60, 64) **gekennzeichnet ist durch** Bereitstellen einer Zeichnung eines dreidimensionalen Objektes und Erstellen eines Modells (10, 18, 26, 30, 36, 44, 50, 56, 60, 64) des dreidimensionalen Objektes **durch** ein Stereolithographie-Verfahren.

## Revendications

1. Procédé pour agencer un élément en relief (14, 20, 28, 32, 46, 52, 58, 62) sur une surface (12) d'un modèle prototype (10, 18, 26, 30, 36, 44, 50, 56, 60, 64) ayant les étapes consistant à :
(a) fournir un modèle (10, 18, 26, 30, 36, 44, 50, 56, 60, 64) ayant au moins une surface (12) sur laquelle on agence ledit élément en relief (14, 20, 28, 32,46, 52, 58, 62),
(b) revêtir ladite surface (12) à l'aide d'une réserve photosensible jusqu'à une épaisseur prédéterminée,
(c) fournir des moyens pour empêcher l'exposition d'une première partie de ladite réserve photosensible à une source de rayonnement tout en permettant l'exposition d'une seconde partie de ladite réserve photosensible, ladite seconde partie de ladite réserve photosensible fournissant ledit élément en relief (14, 20, 28, 32, 46, 52, 58, 62),
(d) exposer ladite surface (12) à ladite source de rayonnement pour altérer chimiquement ladite seconde partie de ladite réserve photosensible,
(e) éliminer ladite première partie de ladite réserve photosensible depuis ladite surface (12) tout en laissant ledit élément en relief (14, 20, 28, 32, 46, 52, 58, 62) formé par ladite réserve photosensible exposée sur ladite surface (12),
**caractérisé en ce que**
ladite étape de revêtement de ladite surface (12) à l'aide de ladite réserve photosensible jusqu'à une épaisseur prédéterminée inclut les étapes consistant à appliquer ladite réserve photosensible sur plus d'une couche et laisser un temps de séchage suffisant entre des couches successives de ladite réserve photosensible.

2. Procédé selon la revendication 1, **caractérisé de plus par** l'étape consistant à : nettoyer ladite surface (12) dudit modèle prototype (10, 18, 26, 30, 36, 44, 50, 56, 60, 64) avant ladite étape de revêtement de ladite surface (12) à l'aide de ladite réserve photosensible.

3. Procédé selon la revendication 1, **caractérisé de plus par** les étapes consistant à : examiner ledit élément en relief (14, 20, 28, 32, 46, 52, 58, 62) après ladite étape d'élimination de ladite première partie de ladite réserve photosensible, et répéter les étapes (b) à (e) pour accentuer ledit élément en relief (14, 20, 28, 32, 46, 52, 58, 62).

4. Procédé selon la revendication 1, dans lequel ladite étape consistant à fournir un modèle (10, 18, 26, 30, 36, 44, 50, 56, 60, 64) est **caractérisée par** la fourniture d'un modèle (10, 18, 26, 30, 36, 44, 50, 56, 60, 64) formé par un procédé stéréolithographique.

5. Procédé selon la revendication 1, dans lequel ladite étape consistant à fournir un modèle (10, 18, 26, 30, 36, 44, 50, 56, 60, 64) est **caractérisée par** la fourniture d'un dessin d'un objet tridimensionnel et par la création d'un modèle (10, 18, 26, 30, 36, 44, 50, 56, 60, 64) dudit objet tridimensionnel par un procédé stéréolithographique.
